# EUROPEAN PATENT SPECIFICATION

(11) **EP 3 858 547 B1**
(45) Date of publication and mention of the grant of the patent: **22.07.2026**
(21) Application number: 19865979.9
(22) Date of filing: 27.09.2019
(51) Int. Cl.: B24B 37/24

(54) **POLISHING PAD AND METHOD FOR PRODUCING POLISHED ARTICLE**
POLIERKISSEN UND VERFAHREN ZUR HERSTELLUNG VON POLIERTEM ARTIKEL
TAMPON DE POLISSAGE ET PROCÉDÉ DE PRODUCTION D'ARTICLE POLI

(30) Priority: 28.09.2018 JP 2018184716; 28.09.2018 JP 2018184915
(43) Date of publication of application: 04.08.2021
(60) Divisional application: 22207836.2
(73) Proprietor: Fujibo Holdings, Inc., Tokyo 103-0013 (JP)
(72) Inventor: MATSUOKA, Ryuma, Saijo-shi, Ehime 799-1342 (JP); KURIHARA, Hiroshi, Saijo-shi, Ehime 799-1342 (JP); NARUSHIMA, Satsuki, Saijo-shi, Ehime 799-1342 (JP); TAKAMIZAWA, Yamato, Saijo-shi, Ehime 799-1342 (JP)
(74) Representative: V.O.
(86) International application number: PCT/JP2019/038091
(87) International publication number: WO 2020/067401

(56) References cited:
- WO-A1-2015/151785
- CN-B- 102 448 669
- JP-A- 2015 193 057
- JP-A- 2016 196 057
- JP-A- 2016 196 058
- JP-B2- 5 254 728
- US-B2- 9 149 905

## Description

### Technical Field

The present invention relates to a polishing pad and a method for producing a polished product.

### Background Art

Chemical mechanical polish-processing by polishing pads with polishing slurries is performed on surfaces (machining surfaces) of materials for semiconductor devices, electronic components and the like, in particular, thin substrates (workpieces) such as Si substrates (silicon wafers), substrates for hard discs, glass, and substrates for LCDs (liquid crystal displays).

Examples of known usage of polishing pads for use in such polish-processing include use of a polishing pad including a polishing layer having an E' ratio of about 1 to 3.6 at 30°C to 90°C, in order to reduce dishing (Patent Literature 1) and use of a polishing pad including, in a polishing layer, a polymer material having a porosity of 0.1% by volume, a KEL energy loss coefficient of 385 to 750 1/Pa at 40°C and 1 rad/sec, and an elastic modulus E' of 100 to 400 MPa at 40°C and 1 rad/sec, in order that both planarization performance and a low defect performance rate are satisfied (Patent Literature 2). CN102448669 B (Patent Literature 3) discloses a polyurethane layer for forming a polishing pad for a semiconductor wafer is described, wherein the polyurethane layer comprises: a foamed polyurethane, wherein the polyurethane foam has a density of about 640 to about 960 kg/m3, and a plurality of cells having an average diameter of about 20 to about 200 micrometers; and particles of a hydrophobic polymer having a critical surface energy of less than 35 mN/m and having a median particle size of 3 to 100 micrometers.

### Citation List

### Patent Literatures

Patent Literature 1: Japanese Translation of PCT International Application Publication No. 2004-507076
Patent Literature 2: Japanese Patent Application Laid-Open No. 2005-136400
Patent Literature 3: Chinese granted patent CN102448669 B

### Summary of Invention

### Technical Problem

However, use of such any polishing pad described in Patent Literatures 1 and 2 cannot be said to provide a high surface grade to the resulting workpiece, and has been found to cause, for example, scratches to be generated.

The present invention has been made in view of the above problems, and an object thereof is to provide a polishing pad that can reduce generation of scratches, and a method for producing a polished product.

### Solution to Problem

The present invention is defined by the independent claims. Embodiments in the description and figures which do not fall within the scope of the claims are to be interpreted as examples or background information.

### Advantageous Effect of Invention

The present invention can provide a polishing pad that can reduce generation of scratches, and a method for producing a polished product.

### Brief Description of Drawings

[Figure 1] Figure 1 is a diagram representing the results of each dynamic viscoelasticity measurement in Examples A1 and B1.
[Figure 2] Figure 2 is a diagram representing the results of each dynamic viscoelasticity measurement in Examples A2 and B2.
[Figure 3] Figure 3 is a diagram representing the results of each dynamic viscoelasticity measurement in Comparative Examples A1 and B1.
[Figure 4] Figure 4 is a diagram representing the results of dynamic viscoelasticity measurement in Comparative Example A2.
[Figure 5] Figure 5 is a diagram representing the results of dynamic viscoelasticity measurement in Comparative Example A3.
[Figure 6] Figure 6 is a diagram representing the results of dynamic viscoelasticity measurement in Comparative Example A4.

### Description of Embodiments

Hereinafter, embodiments of the present invention will be described in detail, but the present invention is not limited thereto and can be variously modified without departing from the scope as defined by the claims.

### [First embodiment: polishing pad]

A polishing pad of a first embodiment includes a polyurethane sheet as a polishing layer, wherein the polyurethane sheet exhibits a peak of loss tangent tan δ in the range from 40 to 60°C in dynamic viscoelasticity measurement performed under conditions of a frequency of 1.6 Hz and a temperature of 20 to 100°C in a water immersion condition.

### (Loss tangent tan δ)

Any loss tangent tan δ is a value represented by the ratio of the loss elastic modulus E" (viscous component) to the storage elastic modulus E' (elastic component), and corresponds to an index indicating the balance between the elasticity and the viscosity exhibited by a substance serving as a measuring object under measurement conditions. Such any loss tangent tan δ is known to be varied depending on whether such a substance serving as a measuring object is in a dry condition or a water immersion condition, and be varied also depending on the frequency in measurement. In the first embodiment, dynamic viscoelasticity of the polishing layer in a dynamic process in polishing is controlled in a predetermined range, resulting in a more improvement in state of contact with a workpiece in polishing, and furthermore suppression of persistent pushing of polishing debris generated by polishing to thereby allow generation of scratches to be suppressed. More specifically, a state where the loss elastic modulus E" (viscous component) is superior to the storage elastic modulus E' (elastic component) under polishing conditions can be exhibited, thereby allowing generation of scratches to be suppressed.

A polishing surface as the surface of the polyurethane sheet is wetted by a slurry under polishing conditions, and is brought into contact with the workpiece by a predetermined polishing operation at a predetermined temperature. Thus, the first embodiment prescribes the following: the polishing layer exhibits a peak of loss tangent tan δ in the temperature range (40 to 60°C) equivalent to that in a polishing step, in dynamic viscoelasticity measurement performed under conditions of a frequency of 1.6 Hz and a temperature of 20 to 100°C in a water immersion condition.

The peak temperature of loss tangent tan δ is 40 to 60°C, preferably 40 to 56°C, more preferably 40 to 52°C. The peak of loss tangent tan δ is within such a temperature range, and therefore a state where the loss elastic modulus E" (viscous component) is superior to the storage elastic modulus E' (elastic component) is exhibited in the range of the temperature equivalent to that in a polishing step, thereby allowing generation of scratches to be suppressed.

Herein, the phrase "having a peak of loss tangent tan δ in the range from 40 to 60°C in dynamic viscoelasticity measurement performed under a condition of 20 to 100°C" means that the local maximum value of loss tangent tan δ in the range from 20 to 100°C is located in the range from 40 to 60°C. In addition, the "peak" in the first embodiment refers to one where the difference between the maximum value and the minimum value is 0.05 or more in the temperature range of ±5°C from the temperature serving as the local maximum value, and no finer variation up and down derived from a noise or the like is construed to be such a peak.

The peak value of loss tangent tan δ is preferably 0.15 to 0.35, more preferably 0.20 to 0.35, further preferably 0.22 to 0.35. The peak value of loss tangent tan δ is within the above range, thereby resulting in tendencies to allow a state where the loss elastic modulus E" (viscous component) is superior to the storage elastic modulus E' (elastic component) to be more effectively exhibited in the temperature range equivalent to that in a polishing step, and allow generation of scratches to be more suppressed.

The value of the loss elastic modulus E" of the polyurethane sheet at 40°C in dynamic viscoelasticity measurement performed under conditions of a frequency of 1.6 Hz and a temperature of 20 to 100°C in a water immersion condition is preferably 21 MPa or more, more preferably 22 to 45 MPa, further preferably 23 to 40 MPa. The value of the loss elastic modulus E" at 40°C is within the above range, thereby resulting in tendencies to allow a state where the loss elastic modulus E" (viscous component) is superior to the storage elastic modulus E' (elastic component) to be more effectively exhibited in the temperature range equivalent to that in a polishing step, and allow generation of scratches to be more suppressed.

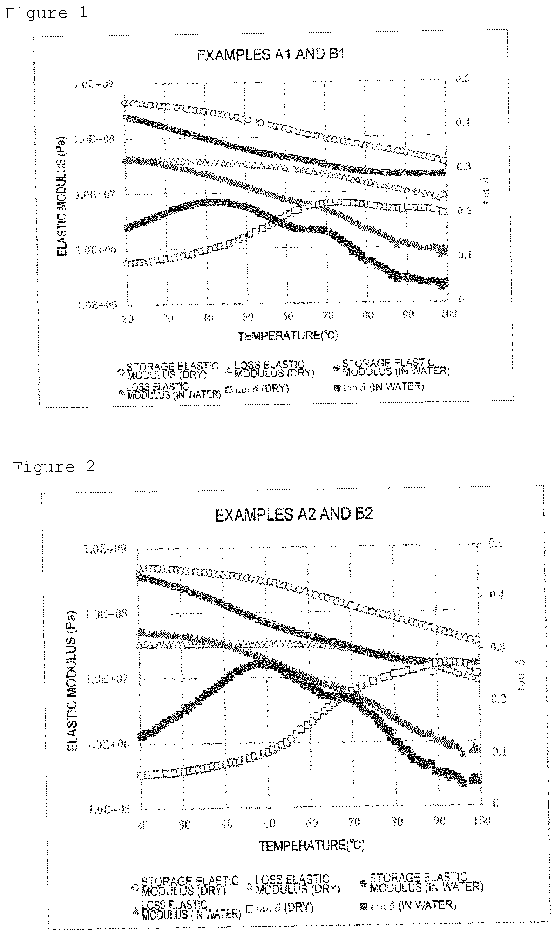

In the polyurethane sheet, a difference A in loss tangent tan δ between 60°C and 70°C is preferably lower than a difference B in loss tangent tan δ between 50°C and 60°C and a difference C in loss tangent tan δ between 70°C and 80°C, in dynamic viscoelasticity measurement performed under conditions of a frequency of 1.6 Hz and a temperature of 20 to 100°C in a water immersion condition. That is, a chart of loss tangent tan δ preferably exhibits a peak shoulder at a higher temperature than any temperature at which the peak is exhibited, as in Figure 1 described below. The chart thus exhibits a peak shoulder at a higher temperature, thereby allowing any relatively high tanδ (in water) to be maintained at a higher temperature than any temperature at which the peak is exhibited. Accordingly, a state where the loss elastic modulus E" (viscous component) is superior to the storage elastic modulus E' (elastic component) can be exhibited in a wider temperature range. Thus, even if any portion locally at a high temperature due to, for example, heat of friction is generated in a polishing step, the storage elastic modulus E' (elastic component) can be inhibited from being superior in the portion, thereby resulting in a tendency to allow generation of scratches to be more suppressed.

In the polyurethane sheet, a difference A in loss tangent tan δ between 60°C and 70°C is preferably 0.010 to 0.035, more preferably 0.010 to 0.030, further preferably 0.012 to 0.028. Furthermore, a difference B in loss tangent tan δ between 50°C and 60°C is preferably 0.035 to 0.060, more preferably 0.038 to 0.050, further preferably 0.040 to 0.045. Furthermore, a difference C in loss tangent tan δ between 70°C and 80°C is preferably 0.055 to 0.095, more preferably 0.060 to 0.090, further preferably 0.065 to 0.085.

The difference between the difference A representing the slope of loss tangent tan δ between 60°C and 70°C and the difference B representing the slope of loss tangent tan δ between 50°C and 60°C, is preferably 0.010 to 0.040, more preferably 0.014 to 0.035, further preferably 0.016 to 0.030. The difference between the difference A representing the slope of loss tangent tan δ between 60°C and 70°C and the difference C representing the slope of loss tangent tan δ between 70°C and 80°C, is preferably 0.030 to 0.080, more preferably 0.040 to 0.070, further preferably 0.050 to 0.060.

The dynamic viscoelasticity measurement in the first embodiment can be performed according to an ordinary method, and the dynamic viscoelasticity measurement in a water immersion condition is performed by using a polishing layer immersed in water at a temperature of 23°C for 3 days, as a sample, and subjecting the sample being immersed in water to such measurement. Examples of any dynamic viscoelasticity measurement apparatus capable of performing such measurement can include DMA8000 manufactured by PerkinElmer Co., Ltd. Other conditions are not particularly limited, and such measurement can be made under conditions described in Examples.

### [Second embodiment: polishing pad]

A polishing pad of a second embodiment includes a polyurethane sheet as a polishing layer, wherein, in the polyurethane sheet, a difference between a peak temperature A of loss tangent tan δ in dynamic viscoelasticity measurement performed under conditions of a frequency of 1.6 Hz and a temperature of 20 to 100°C in a water immersion condition and a peak temperature B of loss tangent tan δ in dynamic viscoelasticity measurement performed under conditions of a frequency of 1.6 Hz and a temperature of 20 to 100°C in a dry condition, is 25 to 47°C.

### (Loss tangent tan δ)

Any loss tangent tan δ is a value represented by the ratio of the loss elastic modulus E" (viscous component) to the storage elastic modulus E' (elastic component), and corresponds to an index indicating the balance between the elasticity and the viscosity exhibited by a substance serving as a measuring object under measurement conditions. Such any loss tangent tan δ is known to be varied depending on whether such a substance serving as a measuring object is in a dry condition or a water immersion condition, and be varied also depending on the frequency in measurement.

A polishing surface as the surface of the polyurethane sheet is either in a relatively more immersed or in a relatively more dried, in a polishing step of bringing the polishing pad into contact with a slurry. Thus, the second embodiment prescribes the following: the difference in peak temperature between the loss tangent tan δ in a water immersion condition and that in a dry condition is within a predetermined range, thereby allowing a state where the loss elastic modulus E" (viscous component) is superior to the storage elastic modulus E' (elastic component) to be exhibited on the entire surface. Thus, not only the state of contact with a workpiece in polishing is more improved on the entire surface, but also persistent pushing of polishing debris generated by polishing is suppressed and generation of scratches is suppressed.

The second embodiment describes, from the above viewpoints, as an index, the difference between the peak temperature A of loss tangent tan δ in dynamic viscoelasticity measurement performed under conditions of a frequency of 1.6 Hz and a temperature of 20 to 100°C in a water immersion condition and the peak temperature B of loss tangent tan δ in dynamic viscoelasticity measurement performed under conditions of a frequency of 1.6 Hz and a temperature of 20 to 100°C in a dry condition. The difference between the peak temperature A and the peak temperature B is 25 to 47°C, preferably 25 to 45°C, more preferably 27 to 45°C. The difference between the peak temperature A and the peak temperature B is within the range, and therefore a state where the loss elastic modulus E" (viscous component) is superior to the storage elastic modulus E' (elastic component) is exhibited on the entire surface, and generation of scratches is suppressed on the entire surface.

Herein, the phrase "peak of loss tangent tan δ in dynamic viscoelasticity measurement performed under a condition of a temperature of 20 to 100°C" means the local maximum value of loss tangent tan δ in the range from 20 to 100°C. In addition, the "peak" in the second embodiment refers to one where the difference between the maximum value and the minimum value is 0.05 or more in the temperature range of ±5°C from the temperature serving as the local maximum value, and no finer variation up and down derived from a noise or the like is construed to be such a peak.

The degree of peak shift from the temperature of loss tangent tan δ in a dry condition to the temperature of loss tangent tan δ in a water immersion condition, namely, the changing ratio of the peak temperature A to the peak temperature B is preferably 0.45 to 0.65, more preferably 0.475 to 0.625, further preferably 0.50 to 0.60. The changing ratio of the peak temperature A to the peak temperature B is within the above range, thereby resulting in tendencies to allow a state where the loss elastic modulus E" (viscous component) is superior to the storage elastic modulus E' (elastic component) to be exhibited on the entire surface and to allow generation of scratches to be suppressed.

The peak temperature A in a water immersion condition is preferably lower than the peak temperature B in a dry condition. Thus, a state where the loss elastic modulus E" (viscous component) is superior to the storage elastic modulus E' (elastic component) can be exhibited at a lower temperature in a substantial portion on a polishing surface brought into contact with a polishing slurry. Thus, there are tendencies to allow a state of contact with a workpiece in polishing to be more improved on the entire surface and to allow generation of scratches to be suppressed.

The peak temperature A in a water immersion condition is preferably 30 to 60°C, more preferably 35 to 55°C, further preferably 40 to 50°C. The peak temperature B in a dry condition is preferably 55 to 95°C, more preferably 65 to 95°C, further preferably 70 to 95°C.

The peak value α of loss tangent tan δ at the peak temperature A is preferably 0.15 to 0.35, more preferably 0.18 to 0.35, further preferably 0.21 to 0.35. The peak value β of loss tangent tan δ at the peak temperature B is preferably 0.15 to 0.35, more preferably 0.18 to 0.35, further preferably 0.21 to 0.35. The peak value α and the peak value β are within the above respective ranges, thereby resulting in tendencies to allow a state where the loss elastic modulus E" (viscous component) is superior to the storage elastic modulus E' (elastic component) to be exhibited on the entire surface and to allow generation of scratches to be suppressed.

The peak value α of loss tangent tan δ at the peak temperature A is preferably equal to or more than the peak value β of loss tangent tan δ at the peak temperature B. More specifically, the difference between the peak value α and the peak value β is preferably 0 to 0.030, more preferably 0 to 0.020, further preferably 0 to 0.010. Thus, a state where the loss elastic modulus E" (viscous component) is superior to the storage elastic modulus E' (elastic component) can be exhibited at a lower temperature in a substantial portion on a polishing surface brought into contact with a polishing slurry. Thus, there are tendencies to allow a state of contact with a workpiece (workpiece) in polishing to be more improved on the entire surface and to allow generation of scratches to be suppressed.

The dynamic viscoelasticity measurement in the second embodiment can be performed according to an ordinary method, and the dynamic viscoelasticity measurement in a water immersion condition is performed by using a polishing layer immersed in water at a temperature of 23°C for 3 days, as a sample, and subjecting the sample being immersed in water to such measurement. The dynamic viscoelasticity measurement in a dry condition is performed by using a polishing layer held in a thermohygrostat bath at a temperature of 23°C (±2°C) and a relative humidity of 50% (±5%) for 40 hours, as a sample, and subjecting the sample to such measurement under a usual air atmosphere (dry condition). Examples of any dynamic viscoelasticity measurement apparatus capable of performing such measurement can include DMA8000 manufactured by PerkinElmer Co., Ltd. Other conditions are not particularly limited, and such measurement can be made under conditions described in Examples.

### (Polyurethane sheet)

A polyurethane sheet is used in such any polishing layer having the above characteristics according to the first embodiment and/or the second embodiment. The polyurethane resin constituting the polyurethane sheet is not particularly limited, and examples thereof include a polyester-based polyurethane resin, a polyether-based polyurethane resin and a polycarbonate-based polyurethane resin. Such a resin may be used singly or in combinations of two or more kinds thereof.

The polyurethane resin is not particularly limited as long as the resin is a reaction product of a urethane prepolymer and a curing agent, and any of various known polyurethane resins can be applied. The urethane prepolymer is not particularly limited, and examples thereof include an adduct of hexamethylene diisocyanate and hexanetriol; an adduct of 2,4-tolylene diisocyanate and brenzcatechol; an adduct of tolylene diisocyanate and hexanetriol; an adduct of tolylene diisocyanate and trimethylolpropane; an adduct of xylylene diisocyanate and trimethylolpropane; an adduct of hexamethylene diisocyanate and trimethylolpropane; and an adduct of isocyanuric acid and hexamethylene diisocyanate. In addition thereto, an isocyanate group-containing compound prepared by a reaction of a polyisocyanate compound and a polyol compound, or any of various commercially available urethane prepolymers may also be used. Such a urethane prepolymer may be used singly or in combinations of two or more kinds thereof.

The polyisocyanate compound for use in the isocyanate group-containing compound is not particularly limited as long as the polyisocyanate compound has two or more isocyanate groups in a molecule. Examples of any diisocyanate compound having two isocyanate groups in a molecule can include m-phenylene diisocyanate, p-phenylene diisocyanate, 2,6-tolylene diisocyanate (2,6-TDI), 2,4-tolylene diisocyanate (2,4-TDI), naphthalene-1,4-diisocyanate, diphenylmethane-4,4'-diisocyanate (MDI), 4,4'-methylene-bis(cyclohexylisocyanate) (hydrogenated MDI), 3,3'-dimethoxy-4,4'-biphenyl diisocyanate, 3,3'-dimethyldiphenylmethane-4,4'-diisocyanate, xylylene-1, 4-diisocyanate, 4,4'-diphenylpropane diisocyanate, trimethylene diisocyanate, hexamethylene diisocyanate, propylene-1,2-diisocyanate, butylene-1,2-diisocyanate, cyclohexylene-1,2-diisocyanate, cyclohexylene-1,4-diisocyanate, p-phenylene diisothiocyanate, xylylene-1,4-diisothiocyanate, and ethylidyne diisothiocyanate.

The polyisocyanate compound is preferably a diisocyanate compound, and in particular, 2,4-TDI, 2,6-TDI, and MDI are more preferable, and 2,4-TDI and 2,6-TDI are particularly preferable.

Such a polyisocyanate compound may be used singly, or a plurality of such polyisocyanate compounds may be combined and used.

The polyisocyanate compound preferably includes 2,4-TDI and/or 2,6-TDI, more preferably includes 2,4-TDI and 2,6-TDI, still more preferably includes only 2,4-TDI and 2,6-TDI. The mass ratio of 2,4-TDI to 2,6-TDI is preferably 100: 0 to 50: 50, more preferably 90: 10 to 60: 40, still more preferably 90: 10 to 70: 30, still more preferably 80: 20.

Examples of the polyol compound for use in the isocyanate group-containing compound can include diol compounds and triol compounds, such as ethylene glycol, diethylene glycol (DEG) and butylene glycol; polyether polyol compounds such as polypropylene glycol (PPG) and poly(oxytetramethylene)glycol (PTMG); polyester polyol compounds such as a reaction product of ethylene glycol and adipic acid, and a reaction product of butylene glycol and adipic acid; and polycarbonate polyol compounds and polycaprolactone polyol compounds. A trifunctional propylene glycol to which ethylene oxide is added can also be used. In particular, PTMG is preferable, and combination use of PTMG and DEG is also preferable. PTMG preferably has a number average molecular weight (Mn) of 500 to 2000, more preferably 500 to 1300, further preferably 500 to 1000, still more preferably 500 to 800. The peak temperature of loss tangent tan δ in the first embodiment can be adjusted by the molecular weight of the polyol compound or a combination of such polyol compounds used. The loss tangent tan δ in a water immersion condition and that in a dry condition in the second embodiment can also be adjusted by the molecular weight of the polyol compound or a combination of such polyol compounds used. The number average molecular weight can be measured by gel permeation chromatography (GPC). In a case where the number average molecular weight of the polyol compound is measured based on a polyurethane resin, it can also be estimated by GPC after decomposition of each component according to an ordinary method such as amine decomposition. Such a polyol compound may be used singly or a plurality of such polyol compounds may be combined and used.

The equivalent of NCO of the urethane prepolymer is preferably 300 to 700, more preferably 350 to 600, further preferably 400 to 500. Herein, the "equivalent of NCO" is determined according to " (Part(s) by mass of polyisocyanate compound + Part(s) by mass of polyol compound)/[(Number of functional groups per polyisocyanate compound molecule × Part(s) by mass of polyisocyanate compound/Molecular weight of polyisocyanate compound) - (Number of functional groups per polyol compound × Part(s) by mass of polyol compound/Molecular weight of polyol compound) ]", and corresponds to the numerical value representing the molecular weight per NCO group of the urethane prepolymer.

The curing agent is not particularly limited, and examples thereof include polyvalent amine compounds such as ethylenediamine, propylenediamine, hexamethylenediamine, isophoronediamine, dicyclohexylmethane-4,4'-diamine, 3,3'-dichloro-4,4'-diaminodiphenylmethane (MOCA), 4-methyl-2,6-bis(methylthio)-1,3-benzenediamine, 2-methyl-4,6-bis(methylthio)-1,3-benzenediamine, 2,2-bis(3-amino-4-hydroxyphenyl)propane, 2,2-bis[3-(isopropylamino)-4-hydroxyphenyl]propane, 2,2-bis[3-(1-methylpropylamino)-4-hydroxyphenyl]propane, 2,2-bis[3-(1-methylpentylamino)-4-hydroxyphenyl]propane, 2,2-bis(3,5-diamino-4-hydroxyphenyl)propane, 2,6-diamino-4-methylphenol, trimethylethylenebis-4-aminobenzoate and polytetramethylene oxide-di-p-aminobenzoate; and polyhydric alcohol compounds such as ethylene glycol, propylene glycol, diethylene glycol, trimethylene glycol, tetraethylene glycol, triethylene glycol, dipropylene glycol, 1,4-butanediol, 1,3-butanediol, 2,3-butanediol, 1,2-butanediol, 3-methyl-1,2-butanediol, 1,2-pentanediol, 1,4-pentanediol, 2,4-pentanediol, 2,3-dimethyltrimethylene glycol, tetramethylene glycol, 3-methyl-4,3-pentanediol, 3-methyl-4,5-pentanediol, 2,2,4-trimethyl-1,3-pentanediol, 1,6-hexanediol, 1,5-hexanediol, 1,4-hexanediol, 2,5-hexanediol, 1,4-cyclohexanedimethanol, neopentyl glycol, glycerin, trimethylolpropane, trimethylolethane, trimethylolmethane, poly(oxytetramethylene)glycol, polyethylene glycol and polypropylene glycol. The polyvalent amine compound may have a hydroxyl group, and examples of such an amine-based compound can include 2-hydroxyethyl ethylenediamine, 2-hydroxyethyl propylenediamine, di-2-hydroxyethyl ethylenediamine, di-2-hydroxyethyl propylenediamine, 2-hydroxypropylethylenediamine and di-2-hydroxypropylethylenediamine.

The polyvalent amine compound is preferably a diamine compound, particularly preferably 3,3'-dichloro-4,4'-diaminodiphenylmethane (MOCA). Examples of MOCA include PANDEX E (manufactured by DIC Corporation) and Iharacuamine MT (manufactured by Kumiai Chemical Industry Co., Ltd.). The polyhydric alcohol compound is, in particular, preferably polypropylene glycol, more preferably polypropylene glycol having a number average molecular weight of 1000 to 3000, still more preferably polypropylene glycol having a number average molecular weight of 1500 to 2500. Such a curing agent may be used singly or in combinations of two or more kinds thereof.

The curing agent is preferably added in an amount of 10 to 60 parts by mass, more preferably 20 to 50 parts by mass, still more preferably 20 to 40 parts by mass based on 100 parts by mass of the urethane prepolymer.

The peak temperature of loss tangent tan δ in the first embodiment can be adjusted by the molecular weight (degree of polymerization) of the urethane prepolymer, and a combination of the urethane prepolymer and the curing agent. The loss tangent tan δ in a water immersion condition and that in a dry condition in the second embodiment can be adjusted by the molecular weight (degree of polymerization) of the urethane prepolymer, and a combination of the urethane prepolymer and the curing agent. These components are preferably mixed from the above viewpoints, by way of example, such that the R value as the equivalent ratio of active hydrogen groups (amino group and hydroxyl group) present in the curing agent to an isocyanate group present at a terminal of the isocyanate group-containing compound as the urethane prepolymer is 0.70 to 1.30, more preferably 0.75 to 1.20, still more preferably 0.80 to 1.10, still more preferably 0.80 to 1.00, still more preferably 0.85 to 0.95.

The polyurethane sheet is preferably a foamed polyurethane sheet having cells. Such cells of the foamed polyurethane sheet are classified to closed cells with a plurality of cells independently present and interconnected cells with a plurality of cells connected as communication holes. In particular, the polyurethane sheet in the first embodiment preferably has closed cells, and is more preferably a polyurethane sheet including a polyurethane resin and a hollow fine particle dispersed in the polyurethane resin. The hollow fine particle is used, thereby resulting in a tendency to facilitate adjustment of the peak temperature of loss tangent tan δ.

A polyurethane sheet having closed cells can be formed by using a hollow fine particle having an outer shell and being in a hollow state. Such a hollow fine particle here used may be a commercially available product or may be one obtained from being synthesized according to an ordinary method. The material of the outer shell of the hollow fine particle is not particularly limited, and examples thereof include polyvinyl alcohol, polyvinylpyrrolidone, poly(meth)acrylic acid, polyacrylamide, polyethylene glycol, polyhydroxyether acrylate, a maleic acid copolymer, polyethylene oxide, polyurethane, poly(meth)acrylonitrile, polyvinylidene chloride, polyvinyl chloride and an organic silicone-based resin, and a copolymer obtained by combining two or more monomers constituting such a resin. Examples of any hollow fine particle being a commercially available product include, but not limited to the following, Expancel series (trade name of Akzo Nobel N.V.) and Matsumoto Microsphere (trade name of Matsumoto Yushi-Seiyaku Co., Ltd.).

The shape of the hollow fine particle in the polyurethane sheet is not particularly limited, and may be, for example, a spherical shape or a substantially spherical shape. The average particle size of the hollow fine particle is not particularly limited, and is preferably 5 to 200 µm, more preferably 5 to 80 µm, further preferably 5 to 50 µm, particularly preferably 5 to 35 µm. The hollow fine particle can also be used to thereby adjust the peak temperature of loss tangent tan δ in the first embodiment. The hollow fine particle can also be used to thereby adjust the peak temperature of loss tangent tan δ in a water immersion condition and that in a dry condition in the second embodiment. The average particle size can be measured with, for example, a laser diffraction particle size distribution measurement apparatus (for example, Mastersizer-2000 manufactured by Spectris).

The hollow fine particle is preferably added in an amount of 0.1 to 10 parts by mass, more preferably 1 to 5 parts by mass, still more preferably 1 to 3 parts by mass based on 100 parts by mass of the urethane prepolymer.

A foaming agent conventionally used may be used in combination with the hollow fine particle, or any gas non-reactive with the above respective components may be blown in the following mixing step, in addition to the above components, as long as the effects of the present invention are not impaired. Examples of the foaming agent include water and a foaming agent mainly containing a hydrocarbon having 5 or 6 carbon atoms. Examples of the hydrocarbon include chain hydrocarbons such as n-pentane and n-hexane, and alicyclic hydrocarbons such as cyclopentane and cyclohexane. For example, any known foam stabilizer, flame retardant, colorant, and/or plasticizer may also be added in addition to the above respective components.

The method for producing the polyurethane sheet is not particularly limited, and examples thereof include a method involving reacting the urethane prepolymer and the curing agent to form a polyurethane resin block and cutting a sheet from the resulting polyurethane resin block. The urethane prepolymer and the curing agent are fed into a mixer and stirred and mixed in the mixing step. In a case where the hollow fine particle is used, the urethane prepolymer, the curing agent and the hollow fine particle can be mixed to thereby provide a polyurethane resin block into which the hollow fine particle is incorporated. The order of mixing is not particularly limited, and preferably, the urethane prepolymer and the hollow fine particle are mixed in advance and the curing agent is fed thereto into a mixer. Thus, a mixed liquid for the polyurethane resin block is prepared. The mixing step is performed in the state where warming is made to a temperature that enables fluidity of each of the above components to be ensured.

For example, the curing agent in a solution of the urethane prepolymer (for example, isocyanate group-containing compound) including the hollow fine particle, warmed to 30 to 90°C, is loaded into a mixer with a jacket whose temperature can be adjusted, and is stirred at 30 to 130°C. Such a mixed liquid may be, if necessary, received in a tank with a jacket having a stirrer, and aged. The stirring time is appropriately adjusted, and is, for example, 0.1 to 60 seconds depending on, for example, the number of teeth, the number of rotations and clearance of the mixer.

In a molding step, the mixed liquid for the polyurethane resin block, prepared in the mixing step, is poured into a mold form pre-heated to 30 to 100°C, and heated and cured at about 100 to 150°C for about 10 minutes to 5 hours, thereby forming a polyurethane resin block. The urethane prepolymer and the curing agent are here reacted to thereby form a polyurethane resin, thereby allowing the mixed liquid to be cured in a state where any cells and/or hollow fine particle are/is dispersed in the polyurethane resin. Thus, a polyurethane resin block including many substantially spherical cells is formed.

The polyurethane resin block obtained in the molding step is then sliced into a sheet shape, and thus the polyurethane sheet is formed. Such slicing allows an open hole to be provided on a sheet surface. The resultant may be here aged at 30 to 150°C for about 1 hour to 24 hours in order that an open hole which is excellent in wear resistance and which is hardly clogged is formed on a polishing layer surface.

A polishing layer having the polyurethane sheet thus obtained, where a double-sided tape is thereafter applied to a surface of the polishing layer, opposite to a polishing surface, is then cut to a predetermined shape, preferably a disc shape, and is finished as any polishing pad according to the first and second embodiments. The double-sided tape here used is not particularly limited, and can be arbitrarily selected from double-sided tapes known in the art.

Such any polishing pad according to the first and second embodiments may have a monolayer structure including only the polishing layer, or may include multiple layers of the polishing layer and other layer (lower layer, support layer) attached on a surface of the polishing layer, opposite to the polishing surface. Characteristics of such other layer is not particularly limited, and a layer more flexible (lower in type A hardness or type D hardness) than the polishing layer is attached on such an opposite surface of the polishing layer, thereby resulting in a further enhancement in polishing flatness. On the other hand, a layer more rigid (higher in type A hardness or type D hardness) than the polishing layer is attached on such an opposite surface of the polishing layer, thereby resulting in a further enhancement in polishing rate.

In the case of a multilayer structure, a plurality of layers may be bonded and fixed by using, for example, a double-sided tape or an adhesive, if necessary, under pressure. The double-sided tape or adhesive here used is not particularly limited, and may be arbitrarily selected from double-sided tapes or adhesives known in the art.

Furthermore, such any polishing pad according to the first and second embodiments, if necessary, may be subjected to a grinding treatment of a front surface and/or a rear surface of the polishing layer, grooving, embossing and/or hole drilling (punching) of the front surface, or attachment of a substrate and/or a pressure-sensitive adhesion layer to the polishing layer, or may include a light transmission portion. The method of the grinding treatment is not particularly limited, and such grinding can be made according to a known method. Specific examples thereof include grinding with sand paper. The shapes of such grooving and embossing are not particularly limited, and examples include lattice-like, concentric, and radial shapes.

### [Method for producing polished product]

Any method for producing a polished product according to first and second embodiments includes a polishing step of polishing a workpiece in the presence of a polishing slurry by use of the polishing pad, thereby providing a polished product. The polishing step may be primary polishing (rough polishing) or final polishing, or both thereof. In particular, such any polishing pad according to the first and second embodiments is preferably used in chemical mechanical polishing. Hereinafter, any method for producing a polished product according to the first and second embodiments will be described with chemical mechanical polishing as an example, but such a method for producing a polished product according to the first and second embodiments is not limited to the following.

The production method involves not only feeding a polishing slurry, but also pushing a workpiece towards the polishing pad by use of a holding surface plate and simultaneously relatively rotating the holding surface plate and a polishing surface plate, thereby polish-processing a machining surface of the workpiece according to chemical mechanical polishing (CMP) with the polishing pad. The holding surface plate and the polishing surface plate may be rotated in the same direction or different directions at rotational speeds different from each other. The workpiece may also be subjected to polish-processing with being moved (in rotation) in a mold during polish-processing.

The polishing slurry may include water, a chemical component such as an oxidant typified by hydrogen peroxide, an additive, and/or an abrasive grain (polishing particle; for example, SiC, SiO₂, Al₂O₃, CeO₂), depending on, for example, the workpiece and polishing conditions.

The workpiece is not particularly limited, and examples thereof include materials for semiconductor devices, electronic components and the like, in particular, thin substrates (workpieces) such as a Si substrate (silicon wafer), a substrate for hard discs, and glass and a substrate for LCDs (liquid crystal displays). In particular, such a method for producing a polished product according to the first and second embodiments can be suitably used in a method for producing, for example, a semiconductor device in which an oxidation layer and a layer of a metal such as copper are formed.

### Examples

Hereinafter, the present invention will be more specifically described with reference to Examples and Comparative Examples. The present invention is not limited to the following Examples at all.

### [First embodiment]

Hereinafter, Examples and Comparative Examples according to the first embodiment correspond to Examples A and Comparative Examples A, respectively.

### [Example A1]

To 100 parts of a urethane prepolymer having an equivalent of NCO of 460 obtained by reacting 2,4-tolylene diisocyanate (TDI), poly(oxytetramethylene)glycol (PTMG) having a number average molecular weight of 650, and diethylene glycol (DEG) was added 2.8 parts of a swollen hollow fine particle including a shell portion made of an acrylonitrile-vinylidene chloride copolymer, incorporating an isobutane gas in the shell and having a size of 15 to 25 µm (average particle size: 20 µm), and the resultant was mixed, thereby providing a mixed liquid of the urethane prepolymer. The resulting mixed liquid of the urethane prepolymer was loaded into a first liquid tank, and the temperature was kept at 80°C. In addition, 25.5 parts of 3,3'-dichloro-4,4'-diaminodiphenylmethane (methylenebis-o-chloroaniline) (MOCA) as a curing agent and 8.5 parts of polypropylene glycol were placed in a second liquid tank separately from the first liquid tank, heated and molten at 120°C and mixed, and furthermore defoamed under reduced pressure, thereby providing a molten liquid of the curing agent.

Next, the respective liquids in the first liquid tank and the second liquid tank were poured into a mixer provided with two inlets, through such inlets, and stirred and mixed, thereby providing a mixed liquid. The mixing ratio thereof here was adjusted such that the R value was 0.90 which represented the equivalent ratio of an amino group and a hydroxyl group present in the curing agent relative to an isocyanate group present at a terminal in the urethane prepolymer.

The resulting mixed liquid was injected into a mold form pre-heated to 100°C, and primarily cured at 110°C for 30 minutes. A molded product having a block shape, here formed, was extracted from the mold form, and secondarily cured in an oven at 130°C for 2 hours, thereby providing a urethane resin block. The resulting urethane resin block was cooled to 25°C, and thereafter heated again in an oven at 120°C for 5 hours and then subjected to a slicing treatment, thereby providing a foamed polyurethane sheet. A double-sided tape was applied onto a rear surface of the resulting polyurethane sheet, and the resultant was used as a polishing pad.

### [Example A2]

To 100 parts of the same urethane prepolymer as in Example A1 were added 3.1 parts of a non-swollen hollow fine particle incorporating an isobutane gas in a shell and having a particle size of 5 to 15 µm (average particle size: 7 µm), and 2 parts of 4,4'-methylenebis(cyclohexylisocyanate) (hydrogenated MDI), and the resultant was mixed, thereby providing a mixed liquid of the urethane prepolymer. Heated and molten was 28 parts of MOCA as a curing agent, and the resultant was mixed, thereby providing a molten liquid of the curing agent. The mixed liquid of the urethane prepolymer and the molten liquid of the curing agent were used to provide a polishing pad according to the same production method as in Example A1.

### [Comparative Example A1]

An IC1000 manufactured by Nitta Haas Incorporated was prepared in Comparative Example A1.

### [Comparative Example A2]

To 100 parts of a urethane prepolymer having an equivalent of NCO of 460 obtained by reacting 2,4-tolylene diisocyanate (TDI), poly(oxytetramethylene)glycol (PTMG) having a number average molecular weight of 650, poly(oxytetramethylene)glycol (PTMG) having a number average molecular weight of 1000, and diethylene glycol (DEG) was added 2.1 parts of a swollen hollow fine particle including a shell portion made of an acrylonitrile-vinylidene chloride copolymer, incorporating an isobutane gas in the shell and having a size of 30 to 50 µm (average particle size: 40 µm), and the resultant was mixed, thereby providing a mixed liquid of the urethane prepolymer. Heated and molten were 27 parts of MOCA as a curing agent and 8.7 parts of polypropylene glycol, and the resultant was mixed and furthermore foamed under reduced pressure, thereby providing a molten liquid of the curing agent. The mixed liquid of the urethane prepolymer and the molten liquid of the curing agent were used to provide a polishing pad according to the same production method as in Example A1.

### [Comparative Example A3]

To 100 parts of the urethane prepolymer in Comparative Example A2 was added 3.0 parts of the same hollow fine particle as that used in Example A1, and the resultant was mixed, thereby providing a mixed liquid of the urethane prepolymer. Heated and molten were 25.8 parts of MOCA as a curing agent and 8.6 parts of polypropylene glycol, and the resultant was mixed and furthermore defoamed under reduced pressure, thereby providing a molten liquid of the curing agent. The mixed liquid of the urethane prepolymer and the molten liquid of the curing agent were used to provide a polishing pad according to the same production method as in Example A1.

### [Comparative Example A4]

To 100 parts of the urethane prepolymer in Comparative Example A2 was added 3.0 parts of the same hollow fine particle as that used in Example A2, and the resultant was mixed, thereby providing a mixed liquid of the urethane prepolymer. Heated and molten were 25.8 parts of MOCA as a curing agent and 8.6 parts of polypropylene glycol, and the resultant was mixed and furthermore defoamed under reduced pressure, thereby providing a molten liquid of the curing agent. The mixed liquid of the urethane prepolymer and the molten liquid of the curing agent were used to provide a polishing pad according to the same production method as in Example A1.

### [Dynamic viscoelasticity measurement]

Each of the polyurethane sheets was subjected to dynamic viscoelasticity measurement under the following conditions. First, such each polyurethane sheet was immersed in water at a temperature of 23°C for 3 days. The resulting polyurethane sheet was used as a sample and subjected to dynamic viscoelasticity measurement in water (water immersion condition). The dynamic viscoelasticity measurement apparatus here used was DMA8000 (manufactured by PerkinElmer Co., Ltd.).

### (Measurement conditions)

Measurement apparatus: DMA8000 (manufactured by PerkinElmer Co., Ltd.)
Sample: 4 cm in length × 0.5 cm in width × 0.125 cm in thickness
Test length: 1 cm
Pre-treatment of sample: retained in water at a temperature of 23°C for 3 days
Test mode: tension
Frequency: 1.6 Hz (10 rad/sec)
Temperature range: 20 to 100°C
Rate of temperature rise: 5°C/min
Strain range: 0.10%
Initial load: 148 g
Measurement interval: 1 point/°C

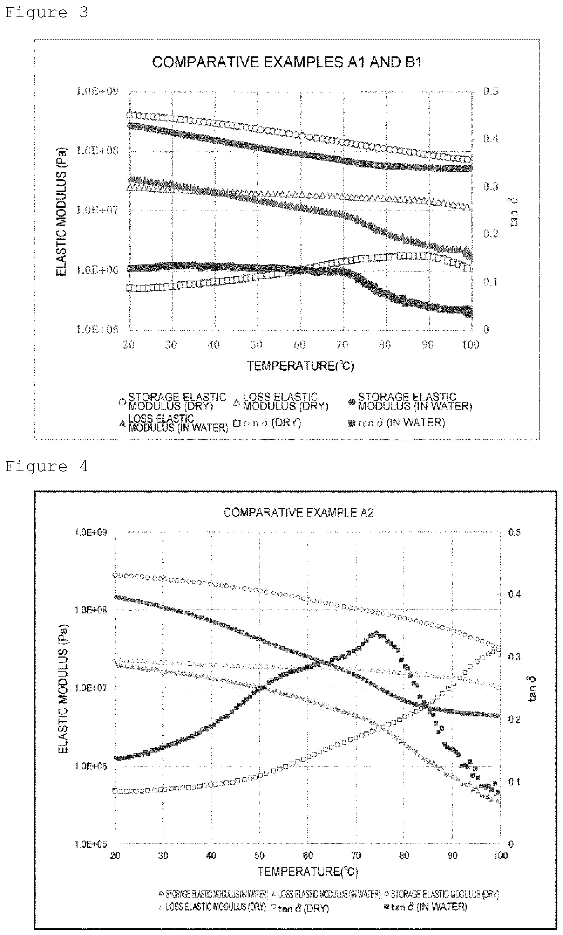

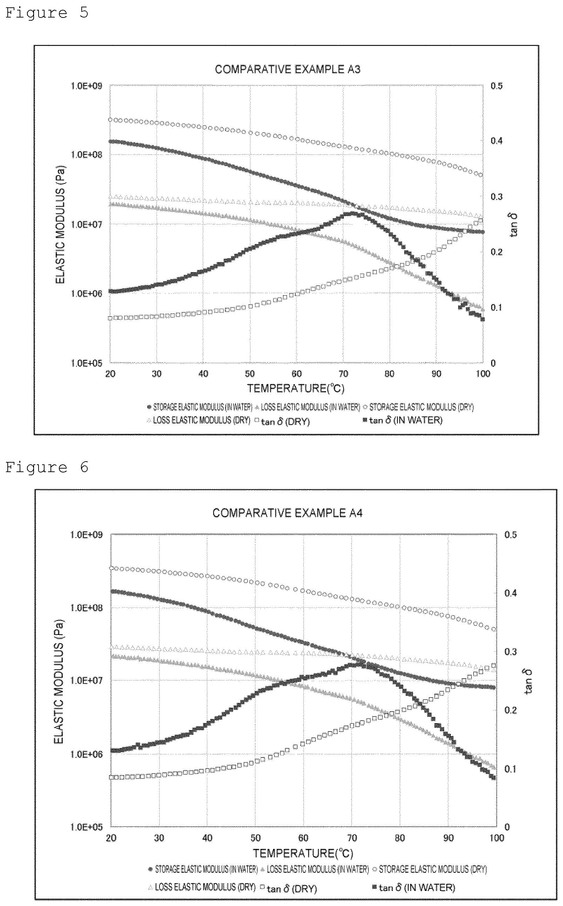

A polyurethane sheet in a dry condition, obtained by retaining a polyurethane sheet in a thermohygrostat bath at a temperature of 23°C (±2°C) and a relative humidity of 50% (±5%) for 40 hours, was used as a sample for reference, and subjected to dynamic viscoelasticity measurement under a usual air atmosphere (dry condition). Such measurement was performed under the same conditions as described above except that RSA3 (manufactured by TA Instruments) was used as an additional apparatus. The results of the dynamic viscoelasticity measurement in Examples A and Comparative Examples A are illustrated in Figures 1 to 6. Those described as (IN WATER) in the Figures correspond to the results of the dynamic viscoelasticity measurement in a water immersion condition, and those described as (DRY) in the Figures correspond to the results of the dynamic viscoelasticity measurement in a dry condition.

### [Test for confirming surface grade]

Each of the polishing pads was placed at a predetermined location of a polishing apparatus with a double-sided tape having an acrylic adhesive being interposed therebetween, and a Cu film substrate was subjected to polish-processing under the following conditions.

### (Polishing conditions)

Polishing machine: F-REX300 (manufactured by Ebara Corporation)
Disk: A188 (manufactured by 3M)
Number of rotations: (surface plate) 70 rpm, (top ring) 71 rpm
Polishing pressure: 0.24 bar (3.5 psi)
Temperature of polishing agent: 20°C
Amount of polishing agent discharged: 200 ml/min
Polishing agent: PLANERLITE 7000 (manufactured by Fujimi Incorporated)
Workpiece: Cu film substrate
Polishing time: 60 seconds
Pad brake: 35 N 10 minutes
Conditioning: Ex-situ, 35 N, 4 scanning

Any straight polishing flaw (scratch) having a size of more than 155 nm was visually confirmed on a polished surface with respect to each workpiece from the tenth workpiece to the fiftieth workpiece after the polish-processing, with Review SEM of eDR5210 (manufactured by KLA Corporation), and the average value was obtained. The surface grade was rated based on the result of such scratch confirmation.

**[Table 1]**

| | | Example A | | Comparative Example A | | | |
|---|---|---|---|---|---|---|---|
| | | 1 | 2 | 1 | 2 | 3 | 4 |
| Water immersion condition | Peak temperature of tanδ (°C) | 41.8 | 47.8 | 35.1 | 74.4 | 72.0 | 72.0 |
| | Peak value of tanδ | 0.231 | 0.276 | 0.137 | 0.337 | 0.269 | 0.277 |
| | Value (MPa) of loss elastic modulus E" at 40°C | 33 | 22 | 20 | 13.3 | 14.2 | 15.4 |
| | Difference A | 0.015 | 0.026 | 0.004 | 0.028 | 0.032 | 0.021 |
| | Difference B | 0.041 | 0.044 | 0.005 | 0.038 | 0.027 | 0.027 |
| | Difference C | 0.069 | 0.080 | 0.043 | 0.027 | 0.033 | 0.033 |
| Surface grade: number of scratches | | 1 | 3 | 5 | 4 | 4 | 4 |

### [Second embodiment]

Hereinafter, Examples and Comparative Examples according to the second embodiment correspond to Examples B and Comparative Examples B, respectively.

### [Example B1]

To 100 parts of a urethane prepolymer having an equivalent of NCO of 450 obtained by reacting 2,4-tolylene diisocyanate (TDI), poly(oxytetramethylene)glycol (PTMG) having a number average molecular weight of 650, and diethylene glycol (DEG) was added 2.8 parts of a swollen hollow fine particle including a shell portion made of an acrylonitrile-vinylidene chloride copolymer, incorporating an isobutane gas in the shell and having a size of 15 to 25 µm (average particle size: 20 µm), and the resultant was mixed, thereby providing a mixed liquid of the urethane prepolymer. The resulting mixed liquid of the urethane prepolymer was loaded into a first liquid tank, and the temperature was kept at 80°C. In addition, 25.5 parts of 3,3'-dichloro-4,4'-diaminodiphenylmethane (methylenebis-o-chloroaniline) (MOCA) as a curing agent and 8.5 parts of polypropylene glycol (PPG) were placed in a second liquid tank separately from the first liquid tank, heated and molten at 120°C and mixed, and furthermore defoamed under reduced pressure, thereby providing a molten liquid of the curing agent.

Next, the respective liquids in the first liquid tank and the second liquid tank were poured into a mixer provided with two inlets, through such inlets, and stirred and mixed, thereby providing a mixed liquid. The mixing ratio thereof here was adjusted such that the R value was 0.90 which represented the equivalent ratio of an amino group and a hydroxyl group present in the curing agent relative to an isocyanate group present at a terminal in the urethane prepolymer.

The resulting mixed liquid was injected into a mold form pre-heated to 100°C, and primarily cured at 110°C for 30 minutes. A molded product having a block shape, here formed, was extracted from the mold form, and secondarily cured in an oven at 130°C for 2 hours, thereby providing a urethane resin block. The resulting urethane resin block was cooled to 25°C, and thereafter heated again in an oven at 120°C for 5 hours and then subjected to a slicing treatment, thereby providing a foamed polyurethane sheet. A double-sided tape was applied onto a rear surface of the resulting polyurethane sheet, and the resultant was used as a polishing pad.

### [Example B2]

To 100 parts of the same urethane prepolymer as in Example B1 were added 3.1 parts of a non-swollen hollow fine particle incorporating an isobutane gas in a shell and having a particle size of 5 to 15 µm (average particle size: 7 µm), and 2 parts of 4,4'-methylenebis(cyclohexylisocyanate) (hydrogenated MDI), and the resultant was mixed, thereby providing a mixed liquid of the urethane prepolymer. Heated and molten was 28 parts of MOCA as a curing agent, and the resultant was mixed, thereby providing a molten liquid of the curing agent. The mixed liquid of the urethane prepolymer and the molten liquid of the curing agent were used to provide a polishing pad according to the same production method as in Example B1.

### [Comparative Example B1]

An IC1000 manufactured by Nitta Haas Incorporated was prepared in Comparative Example B1.

### [Dynamic viscoelasticity measurement]

Each of the polyurethane sheets was subjected to dynamic viscoelasticity measurement under the following conditions. First, such each polyurethane sheet was immersed in water at a temperature of 23°C for 3 days. The resulting polyurethane sheet was used as a sample and subjected to dynamic viscoelasticity measurement in water (water immersion condition). The dynamic viscoelasticity measurement apparatus here used was DMA8000 (manufactured by PerkinElmer Co., Ltd.).

### (Measurement conditions)

Measurement apparatus: DMA8000 (manufactured by PerkinElmer Co., Ltd.)
Sample: 4 cm in length × 0.5 cm in width × 0.125 cm in thickness
Test length: 1 cm
Pre-treatment of sample: retained in water at a temperature of 23°C for 3 days
Test mode: tension
Frequency: 1.6 Hz (10 rad/sec)
Temperature range: 20 to 100°C
Rate of temperature rise: 5°C/min
Strain range: 0.10%
Initial load: 148 g
Measurement interval: 1 point/°C

A polyurethane sheet in a dry condition, obtained by retaining a polyurethane sheet in a thermohygrostat bath at a temperature of 23°C (±2°C) and a relative humidity of 50% (±5%) for 40 hours, was used as a sample, and subjected to dynamic viscoelasticity measurement under a usual air atmosphere (dry condition). Such measurement was performed under the same conditions as described above except that RSA3 (manufactured by TA Instruments) was used as an additional apparatus. The results of the dynamic viscoelasticity measurement in Examples B and Comparative Examples B are illustrated in Figures 1 to 3. Those described as (IN WATER) in the Figures correspond to the results of the dynamic viscoelasticity measurement in a water immersion condition, and those described as (DRY) in the Figures correspond to the results of the dynamic viscoelasticity measurement in a dry condition.

### [Test for confirming surface grade]

Each of the polishing pads was placed at a predetermined location of a polishing apparatus with a double-sided tape having an acrylic adhesive being interposed therebetween, and a Cu film substrate was subjected to polish-processing under the following conditions.

### (Polishing conditions)

Polishing machine: F-REX300 (manufactured by Ebara Corporation)
Disk: A188 (manufactured by 3M)
Number of rotations: (surface plate) 70 rpm, (top ring) 71 rpm
Polishing pressure: 0.24 bar (3.5 psi)
Temperature of polishing agent: 20°C
Amount of polishing agent discharged: 200 ml/min
Polishing agent: PLANERLITE 7000 (manufactured by Fujimi Incorporated)
Workpiece: Cu film substrate
Polishing time: 60 seconds
Pad brake: 35 N 10 minutes
Conditioning: Ex-situ, 35 N, 4 scanning

Any point-like polishing flaw (micro scratch) having a size of more than 155 nm was visually confirmed on a polished surface with respect to each workpiece from the tenth workpiece to the fiftieth workpiece after the polish-processing, with Review SEM of eDR5210 (manufactured by KLA Corporation), and the average value was obtained. The surface grade was rated based on the result of such scratch confirmation.

**[Table 2]**

| | Example B1 | Example B2 | Comparative Example B1 |
|---|---|---|---|
| Peak temperature A (°C) of tanδ (water immersion condition) | 41.8 | 47.8 | 35.1 |
| Peak temperature B (°C) of tanδ (dry condition) | 72.4 | 92.1 | 85.5 |
| Difference (°C) between peak temperature A of tanδ and peak temperature B of tanδ | 30.6 | 44.3 | 49.6 |
| Changing ratio of peak temperature A to peak temperature B | 0.58 | 0.52 | 0.41 |
| Peak value α (water immersion condition) | 0.231 | 0.276 | 0.137 |
| Peak value β (dry condition) | 0.226 | 0.276 | 0.157 |
| Surface grade: number of micro scratches | 9 | 25 | 30 |

Each scratch evaluated in Examples A and each micro scratch evaluated in Examples B are different from each other in that whether each polishing flaw was a straight or dot-like shape. Mostly, any straight polishing flaw easily occurs due to polishing pad debris and/or a large slurry aggregate, and any dot-like polishing flaw easily occurs due to polishing pad debris and/or a small slurry aggregate.

### Industrial Applicability

The polishing pad of the present invention is used for polishing, for example, an optical material, a semiconductor device, and a substrate for hard discs, and has industrial applicability particularly as a polishing pad suitably used for polishing a device where an oxide layer, a layer of a metal such as copper, and the like are formed on a semiconductor wafer.

## Claims

1. A polishing pad comprising a polyurethane sheet as a polishing layer,
wherein the polyurethane sheet exhibits a peak of loss tangent tan δ, that is the ratio of the loss elastic modulus E" and the storage elastic modulus E', in the range from 40 to 60°C in dynamic viscoelasticity measurement performed using a sample 4cm in length,0.5cm in width, and 0.125cm in thickness, a test length of 1cm, which sample is pre-treated by being retained in water at a temperature of 23°C for 3 days, wherein the dynamic viscoelasticity measurement is performed under conditions of a tension test mode; a frequency of 1.6 Hz; a temperature of 20 to 100°C in a water immersion condition; a rate of temperature increase of 5°C/min; a strain range of 0.1%, an initial load of 148g; and a measurement interval of 1 point/°C.

2. The polishing pad according to claim 1, wherein a value of the peak of loss tangent tan δ is 0.15 to 0.35.

3. The polishing pad according to claim 1 or 2, wherein the polyurethane sheet has a value of a loss elastic modulus E" at 40°C, of 21 MPa or more, in dynamic viscoelasticity measurement performed using a sample 4 cm in length, 0.5 cm in width, and 0.125 cm in thickness, a test length of 1 cm, which sample is pre-treated by being retained in water at a temperature of 23°C for 3 days, wherein the dynamic viscoelasticity measurement is performed under conditions of a tension test mode; a frequency of 1.6 Hz; a temperature of 20 to 100°C in a water immersion condition; a rate of temperature increase of 5° C/min; a strain range of 0.1%, an initial load of 148 g; and a measurement interval of 1 point/°C.

4. The polishing pad according to any one of claims 1 to 3, wherein, in the polyurethane sheet, a difference A in loss tangent tan δ between 60°C and 70°C is lower than a difference B in loss tangent tan δ between 50°C and 60°C and a difference C in loss tangent tan δ between 70°C and 80°C, in dynamic viscoelasticity measurement performed using a sample 4 cm in length, 0.5 cm in width, and 0.125 cm in thickness, a test length of 1 cm, which sample is pre-treated by being retained in water at a temperature of 23°C for 3 days, wherein the dynamic viscoelasticity measurement is performed under conditions of a tension test mode; a frequency of 1.6 Hz; a temperature of 20 to 100°C in a water immersion condition; a rate of temperature increase of 5° C/min; a strain range of 0.1%, an initial load of 148 g; and a measurement interval of 1 point/°C.

5. The polishing pad according to any one of claims 1 to 4, wherein the polyurethane sheet comprises a polyurethane resin and a hollow fine particle dispersed in the polyurethane resin.

6. A method for producing a polished product, comprising
a polishing step of polishing a workpiece in the presence of a polishing slurry by use of the polishing pad according to any one of claims 1 to 5.

## Patentansprüche

1. Polierpad, aufweisend eine Polyurethanfolie als eine Polierschicht,
wobei die Polyurethanfolie einen Peak eines Verlust-Tangens tan δ aufweist, der das Verhältnis des Verlust-Elastizitätsmoduls E" und des Speicher-Elastizitätsmoduls E' in dem Bereich von 40 bis 60°C in einer Messung der dynamischen Viskoelastizität ist, die unter der Verwendung einer Probe durchgeführt wird, die eine Länge von 4 cm, eine Breite von 0,5 cm und eine Dicke von 0,125 cm hat, mit einer Testlänge von 1 cm, wobei die Probe dadurch vorbehandelt wird, dass sie 3 Tage lang in Wasser bei einer Temperatur von 23°C gelagert wird, wobei die Messung der dynamischen Viskoelastizität unter Bedingungen eines Spannungs-Testmodus; einer Frequenz von 1,6 Hz; einer Temperatur von 20 bis 100°C unter einer in Wasser eingetauchten Bedingung; einer Rate des Temperaturanstiegs von 5°C/min; einem Dehnungsbereich von 0,1 %, einer anfänglichen Last von 148 g; und einem Messintervall von 1 Punkt/°C durchgeführt wird.

2. Polierpad gemäß Anspruch 1, wobei ein Wert des Peaks des Verlust-Tangens tan δ 0,15 bis 0,35 beträgt.

3. Polierpad gemäß Anspruch 1 oder 2, wobei die Polyurethanfolie einen Wert eines Verlust-Elastizitätsmoduls E" bei 40°C von 21 MPa oder mehr in einer Messung der dynamischen Viskoelastizität hat, die unter Verwendung einer Probe durchgeführt wird, die eine Länge von 4 cm, eine Breite von 0,5 cm und ein Dicke von 0,125 cm hat, mit einer Testlänge von 1 cm, wobei die Probe dadurch vorbehandelt wird, dass sie 3 Tage lang in Wasser bei einer Temperatur von 23°C gelagert wird, wobei die Messung der dynamischen Viskoelastizität unter Bedingungen eines Spannungs-Testmodus; einer Frequenz von 1,6 Hz; einer Temperatur von 20 bis 100°C unter einer in Wasser eingetauchten Bedingung; einer Rate des Temperaturanstiegs von 5°C/min; einem Dehnungsbereich von 0,1 %, einer anfänglichen Last von 148 g; und einem Messintervall von 1 Punkt/°C durchgeführt wird.

4. Polierpad gemäß einem der Ansprüche 1 bis 3, wobei in der Polyurethanfolie eine Differenz A in dem Verlust-Tangens tan δ zwischen 60°C und 70°C kleiner als eine Differenz B in dem Verlust-Tangens tan δ zwischen 50°C und 60°C und eine Differenz C in dem Verlust-Tangens tan δ zwischen 70°C und 80°C in einer Messung der dynamischen Viskoelastizität ist, die unter der Verwendung einer Probe durchgeführt wird, die eine Länge von 4 cm, eine Breite von 0,5 cm und eine Dicke von 0,125 cm hat, mit einer Testlänge von 1 cm, wobei die Probe dadurch vorbehandelt wird, dass sie 3 Tage lang in Wasser bei einer Temperatur von 23°C gelagert wird, wobei die Messung der dynamischen Viskoelastizität unter Bedingungen eines Spannungs-Testmodus; einer Frequenz von 1,6 Hz; einer Temperatur von 20 bis 100°C unter einer in Wasser eingetauchten Bedingung; einer Rate des Temperaturanstiegs von 5°C/min; einem Dehnungsbereich von 0,1 %, einer anfänglichen Last von 148 g; und einem Messintervall von 1 Punkt/°C durchgeführt wird.

5. Polierpad gemäß einem der Ansprüche 1 bis 4, wobei die Polyurethanfolie ein Polyurethanharz und einen in dem Polyurethanharz dispergierten hohlen feinen Partikel aufweist.

6. Verfahren zum Herstellen eines polierten Produkts, aufweisend
einen Polierschritt zum Polieren eines Werkstücks in der Anwesenheit eines Polierschlamms durch die Verwendung des Polierpads gemäß einem der Ansprüche 1 bis 5.

## Revendications

1. Tampon de polissage comprenant une feuille de polyuréthane servant de couche de polissage,
dans lequel la feuille de polyuréthane présente un pic de facteur de perte tan δ, qui est le rapport du module élastique de perte E" et du module élastique de conservation E', situé dans la plage allant de 40 à 60 °C lors d'une mesure de viscoélasticité dynamique réalisée en utilisant un échantillon ayant une longueur de 4 cm, une largeur de 0,5 cm et une épaisseur de 0,125 cm, une longueur de test de 1 cm, lequel échantillon est prétraité en étant maintenu dans de l'eau à une température de 23 °C pendant 3 jours, dans lequel la mesure de viscoélasticité dynamique est effectuée dans les conditions suivantes : mode de test : tension ; fréquence : 1,6 Hz ; température : 20 à 100 °C dans une condition d'immersion dans de l'eau ; vitesse de montée en température : 5 °C/min ; plage de déformation : 0,1 % ; charge initiale : 148 g ; et intervalle de mesure : 1 point/°C.

2. Tampon de polissage selon la revendication 1, dans lequel la valeur du pic de facteur de perte tan δ est de 0,15 à 0,35.

3. Tampon de polissage selon la revendication 1 ou 2, dans lequel la feuille de polyuréthane a une valeur de module élastique de perte E" à 40 °C de 21 MPa ou plus lors d'une mesure de viscoélasticité dynamique effectuée en utilisant un échantillon ayant une longueur de 4 cm, une largeur de 0,5 cm et une épaisseur de 0,125 cm, une longueur de test de 1 cm, lequel échantillon est prétraité en étant maintenu dans de l'eau à une température de 23 °C pendant 3 jours, dans lequel la mesure de viscoélasticité dynamique est effectuée dans les conditions suivantes : mode de test : tension ; fréquence : 1,6 Hz ; température : 20 à 100 °C dans une condition d'immersion dans de l'eau ; vitesse de montée en température : 5 °C/min ; plage de déformation : 0,1 % ; charge initiale : 148 g ; et intervalle de mesure : 1 point/°C.

4. Tampon de polissage selon l'une quelconque des revendications 1 à 3, dans lequel, dans la feuille de polyuréthane, la différence A de facteur de perte tan δ entre 60 °C et 70 °C est inférieure à la différence B de facteur de perte tan δ entre 50 °C et 60 °C et à la différence C de facteur de perte tan δ entre 70 °C et 80 °C, lors d'une mesure de viscoélasticité dynamique effectuée en utilisant un échantillon ayant une longueur de 4 cm, une largeur de 0,5 cm et une épaisseur de 0,125 cm, une longueur de test de 1 cm, lequel échantillon est prétraité en étant maintenu dans de l'eau à une température de 23 °C pendant 3 jours, dans lequel la mesure de viscoélasticité dynamique est effectuée dans les conditions suivantes : mode de test : tension ; fréquence : 1,6 Hz ; température : 20 à 100 °C dans une condition d'immersion dans de l'eau ; vitesse de montée en température : 5 °C/min ; plage de déformation : 0,1 % ; charge initiale : 148 g ; et intervalle de mesure : 1 point/°C.

5. Tampon de polissage selon l'une quelconque des revendications 1 à 4, dans lequel la feuille de polyuréthane comprend une résine de polyuréthane et de fines particules creuses dispersées dans la résine de polyuréthane.

6. Procédé pour produire un produit poli, comprenant
une étape de polissage dans laquelle une pièce à travailler est polie en présence d'une bouillie de polissage par utilisation du tampon de polissage de l'une quelconque des revendications 1 à 5.
